Europäisches Patentamt

European Patent Office

Office européen des brevets

(11) Numéro de publication: **0 228 748 B1**

# (12) FASCICULE DE BREVET EUROPEEN

(45) Date de publication de fascicule du brevet:
24.07.91

(51) Int. Cl.5: **H01L 29/08, H01L 29/72**

(21) Numéro de dépôt: 86202321.5

(22) Date de dépôt: **18.12.86**

Le dossier contient des informations techniques présentées postérieurement au dépôt de la demande et ne figurant pas dans le présent fascicule.

(54) Procédé de fabrication d'un transistor latéral intégré et circuit intégré le comprenant.

(30) Priorité: 31.12.85 FR 8519479

(43) Date de publication de la demande:
15.07.87 Bulletin 87/29

(45) Mention de la délivrance du brevet:
24.07.91 Bulletin 91/30

(84) Etats contractants désignés:
DE FR GB IT NL

(56) Documents cités:
FR-A- 2 365 213
US-A- 4 167 425

IBM TECHNICAL DISCLOSURE BULLETIN, vol. 24, no. 9, février 1982, pages 4460,4461, New York, US; R.A. MUGGLI: "Annular emitter lateral PNP transistor"

(73) Titulaire: **PHILIPS COMPOSANTS**
**117, quai du Président Roosevelt**
**F-92130 Issy les Moulineaux(FR)FR**

Titulaire: **N.V. Philips' Gloeilampenfabrieken**
**Groenewoudseweg 1**
**NL-5621 BA Eindhoven(NL)DE GB IT NL**

(72) Inventeur: **Jacques, Bertrand**
**Société Civile SPID 209, rue de l'Université**
**F-75007 Paris(FR)**
Inventeur: **Leduc, Pierre**
**Société Civile SPID 209, rue de l'Université**
**F-75007 Paris(FR)**

(74) Mandataire: **Jacquard, Philippe et al**
**Société Civile S.P.I.D. 156, Boulevard Haussmann**
**F-75008 Paris(FR)**

EP 0 228 748 B1

## Description

La présente invention a pour objet un procédé de fabrication d'un transistor latéral intégré dans lequel des régions d'émetteur et de collecteur d'un premier type de conductivité espacées latéralement sont réalisées â partir de la surface d'une région d'un deuxième type de conductivité opposé au premier, l'espace latéral de ladite région du deuxième type situé entre les régions d'émetteur et de collecteur formant une région de base du transistor, procédé dans lequel on réalise ensuite, à travers des fenêtres d'une couche isolante déposée au moins sur lesdites régions d'émetteur et de collecteur, des liaisons électriques d'émetteur et de collecteur dont chacune présente une zone en contact électrique respectivement avec ladite région d'émetteur et avec ladite région de collecteur.

Un tel procédé est connu du certificat d'utilité français FR 2254106 (NATIONAL SEMI CONDUCTOR) en sa figure 1.

Il est bien connu de l'homme de l'art que les gains en courant des transistors latéraux sont limités à cause du phénomène d'injection verticale. Les solutions proposées jusqu'à présent consistent à diminuer la surface de l'émetteur pour diminuer l'injection verticale, et donc augmenter le gain en courant. Pour réaliser un transistor latéral, l'homme de l'art choisit en général une surface de contact d'émetteur aussi petite que le permet la technologie de fabrication, et réalise en conséquence un émetteur également aussi petit que possible en tenant compte des tolérances de positionnement correspondant au procédé choisi, de manière à éviter que le contact d'émetteur ne réalise un court-circuit émetteur-base.

Un certain nombre de solutions ont été proposées pour diminuer le phénomène d'injection verticale, en limitant la surface effective de l'émetteur. Elles ont pour conséquence de nécessiter soit une modification du procédé, soit l'adjonction à celui-ci d'une étape supplémentaire.

Le brevet français 2 028 146 (N.V. PHILIPS) envisage,pour limiter l'injection verticale de réaliser la zone émettrice comme une très petite zone superficielle. Une zone aussi petite étant impossible à réaliser, ce brevet propose alors comme solution de réaliser une zone émettrice plus épaisse que la zone collectrice de manière que seule la zone émettrice atteigne une couche enterrée.

Ce procédé connu nécessite une diffusion supplémentaire et a l'inconvénient d'augmenter la capacité émetteur-base.

Le brevet français 2365213 (THOMSON-CSF) propose de diffuser dans l'émetteur une zone très fortement dopée et de type opposé à celui de l'émetteur, un contact électrique recouvrant au moins en partie la surface apparente de la jonction entre cette zone très fortement dopée et l'émetteur. Il est clair que cette solution implique également une étape supplémentaire de procédé.

La Demanderesse s'est aperçu que de manière tout à fait surprenante le fait de minimiser globalement la surface d'injection verticale ne conduisait pas nécessairement au meilleur gain possible pour un transistor latéral à faible épaisseur d'émetteur tels ceux fabriqués dans une couche épitaxiale mince en technologie à isolation par oxyde.

L'invention proposée a pour but un procédé permettant d'augmenter le gain des transistors latéraux en optimisant la géométrie de l'émetteur du transistor, d'une manière qui corresponde véritablement au phénomène d'injection verticale, ce qui conduit, en contradiction avec l'enseignement de l'art antérieur, à augmenter les dimensions de l'émetteur.

Le procédé selon l'invention est ainsi caractérisé en ce que la profondeur et le niveau de dopage de ladite région d'émetteur sont tels que la longueur de diffusion des porteurs minoritaires injectés verticalement dans celui-ci est supérieure ou égale à l'épaisseur de ladite région et en ce que la distance entre les périphéries de ladite zone de liaison électrique d'émetteur et de la région d'émetteur est, au moins sur une partie desdites périphéries en regard, nominalement supérieure à la tolérance d'alignement entre une dite fenêtre et une dite région d'émetteur et est choisie de manière telle que le gain du transistor soit supérieur à celui d'un transistor de même surface de liaison électrique d'émetteur et dont ladite distance entre les périphéries de ladite zone de liaison électrique d'émetteur et de ladite région d'émetteur est égale nominalement à ladite tolérance d'alignement.

La première caractéristique exprime la condition que la zone de liaison électrique d'émetteur occupe une plus faible part de la surface d'émetteur que dans l'art antérieur. La deuxième caractéristique exprime la condition que ce rapport est choisi inférieur à une valeur pour laquelle le gain serait redevenu égal au gain d'un transistor de l'art antérieur.

Ladite zone de liaison électrique d'émetteur peut avantageusement présenter la surface minimale permise par le procédé.

Ladite zone de liaison électrique peut être un premier carré de côté L1 s'inscrivant dans un deuxième carré de côté L2 constituant ladite région d'émetteur, L2 - L1 étant supérieur à deux fois ladite tolérance d'alignement.

2

Le rapport entre la surface de ladite région d'émetteur et celle de ladite zone de liaison électrique d'émetteur peut être compris entre 20 et 200. Selon un mode préféré, ledit rapport est sensiblement égal à r, r désignant le rapport entre la densité d'injection sous ladite zone de liaison électrique d'émetteur et la densité d'injection sous ladite couche isolante.

L'invention concerne également un dispositif semiconducteur, notamment un circuit intégré présentant un transistor latéral comportant des régions d'émetteur et de collecteur d'un premier type de conductivité espacées latéralement et disposées à partir de la surface d'une région d'un deuxième type de conductivité opposé au premier, l'espace latéral de ladite région du deuxième type situé entre les régions d'émetteur et de collecteur formant la base du transistor, et comportant des liaisons électriques d'émetteur et de collecteur dont chacune présente une zone en contact électrique à travers des fenêtres d'une couche isolante respectivement avec ladite région d'émetteur et avec ladite région de collecteur.

Un tel transistor est également connu du certificat d'utilité français FR 2254106 (NATIONAL SEMICONDUCTOR) en sa figure 1. Selon l'invention, la géométrie du transistor est optimisée de manière à tenir compte véritablement du phénomène d'injection verticale, ceci en contradiction avec l'article antérieur déjà cité qui conduit à minimiser la surface d'émetteur.

Le transistor selon l'invention est ainsi caractérisé en ce que la région d'emetteur présente une profondeur et un niveau de dopage tel que la longueur de diffusion des porteurs minoritaires injectés verticalement dans celle-ci est supérieure ou égale à l'épaisseur de ladite jonction et en ce que le rapport entre la surface de ladite région d'émetteur et celle de ladite zone de liaison électrique d'émetteur est compris entre 20 et 200.

Selon un mode préféré, ce rapport est sensiblement égal à r, r désignant le rapport entre la densité d'injection sous ladite zone de liaison électrique d'émetteur et la densité d'injection sous ladite couche isolante.

La zone de liaison électrique d'émetteur peut être un premier carré de côté $L_1$ s'inscrivant dans un deuxième carré de côté $L_2$ constituant ladite région d'émetteur, le rapport

$$\frac{L_2{}^2}{L_1{}^2}$$

étant compris entre 20 et 200, la région de collecteur ayant un contour intérieur carré entourant la région d'émetteur.

L'invention sera mieux comprise à la lecture dans la description qui va suivre donnée à titre d'exemple non limitatif, en liaison avec les dessins qui représentent :
- Les figures 1 et 2, un transistor latéral de l'art antérieur ;
- Les figures 3a et 3b, un transistor latéral selon un mode de réalisation de l'invention, et la figure 4, une courbe dudit transistor montrant $\beta$ en fonction du rapport $L_2/L_1$.

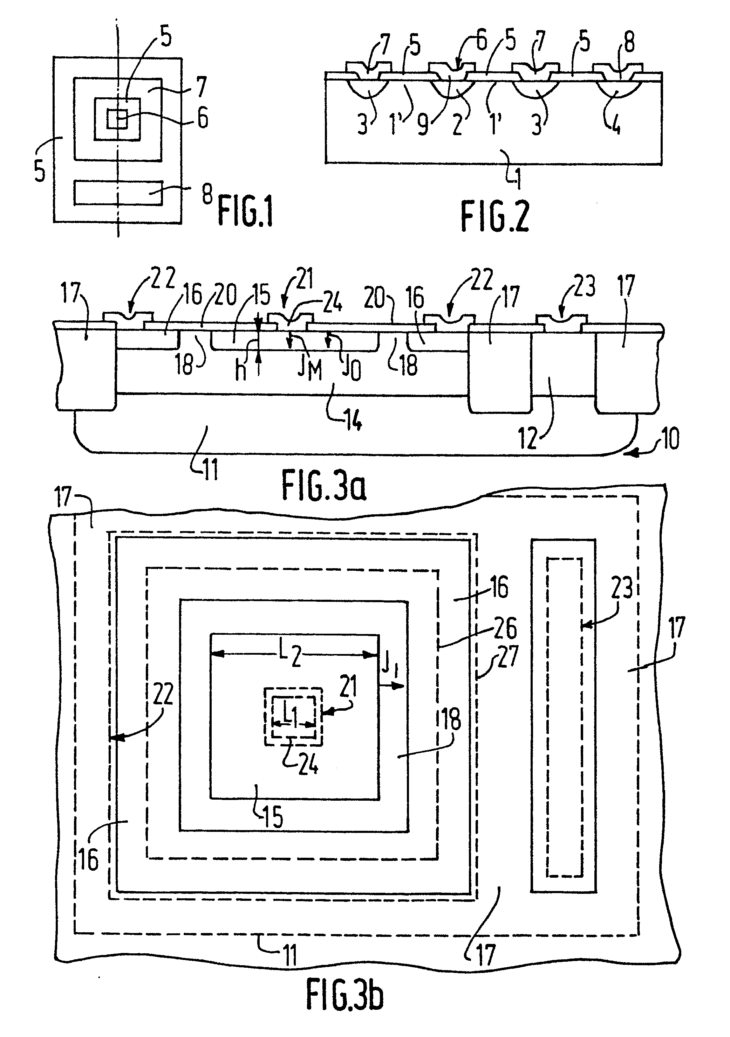

Selon les figures 1 et 2, un transistor latéral tel que décrit dans le certificat d'utilité français FR 2254106 (NATIONAL SEMICONDUCTOR), comporte une région d'émetteur 2 de forme carrée et une région de collecteur 3 de contours extérieurs et intérieurs carrés d'un premier type de conductivité diffusés dans un corps semi-conducteur 1 du deuxième type de conductivité. La base du transistor est constitué par la partie 1' du corps 1 située entre les régions d'émetteur et de collecteur. Une région 4 fortement dopée du deuxième type de conductivité est également diffusée dans le corps 1 en dehors de la région de collecteurs, et sert à faciliter la prise de contact de base. Les prises de contact d'émetteur, 6, de base 8 et de collecteur 7 sont réalisées à travers des ouvertures d'une couche 5 de SiO₂ alignées avec les régions sous jacentes d'émetteur, de base et de collecteurs. On a désigné par 9 la zone dans laquelle la prise de contact 6 d'émetteur est effectivement en contact électrique avec l'émetteur.

Selon l'art antérieur, un tel contact d'émetteur 6 est réalisé de telle manière que la zone 9 occupe la plus grande partie possible de la surface de l'émetteur ce qui en outre minimise la résistance d'émetteur, une faible résistance d'émetteur étant à priori favorable à un gain en courant élevé. Pour obtenir un gain en courant optimal, il est par ailleurs souhaité que l'émetteur soit le plus petit possible. Il est de ce fait usuel de donner à la zone 9 la plus petite surface possible compatible avec le procédé, et de réaliser un émetteur 2 ayant la plus petite surface possible compatible avec la tolérance d'alignement de l'ouverture correspondant au contact 6. Il faut en effet éviter que la zone 9 ne court-circuite la jonction émetteur-base. Cette tolérance d'alignement est égale à la tolérance nominale de positionnement des masques par exemple de l'ordre de 2 microns augmentée d'une valeur de sécurité (en général inférieure à 1 micron).

L'évolution générale de la technique des circuits intégrés à conduit à la mise en oeuvre de procédés à isolation par oxyde de tel que celui décrit par exemple dans le brevet français n° 1.549.386 (N.V. PHILIPS) et dans son addition 2.081.017.

Dans de tels procédés, les composants sont réalisés dans une couche épitaxiale mince (d'épaisseur de l'ordre de 1,5 micron), et sont isolés entre eux par des caissons de SiO₂ qui atteignent le substrat sur lequel est réalisé la couche épitaxiale. Les caissons peuvent être refermés vers le bas par une couche enterrée de conductivité opposée à celle du substrat. La réalisation de transistors latéraux dans une telle technologie conduit pour les émetteurs à des épaisseurs et à des niveaux de dopage tels que la longueur de diffusion des porteurs minoritaires injectés verticalement est supérieure ou égale à l'épaisseur des émetteurs, autrement dit que les porteurs injectés verticalement dans un émetteur le traversent.

La Demanderesse a mis en évidence que, pour un transistor latéral dont l'émetteur est tel que la longueur de la diffusion des porteurs minoritaires injectés verticalement dans celui-ci est supérieure ou égale à l'épaisseur de l'émetteur, les critères utilisés précédemment (surface de contact maximale sur une surface d'émetteur minimale) n'étaient plus optimaux. Il lui a en outre été possible de rendre compte du phénomène d'injection vertical propre à une telle configuration à partir de certaines hypothèses théoriques sur les propriétés d'une telle injection, et qui ont été vérifiées expérimentalement. Celles-ci ont permis d'aboutir à un modèle d'injection simplifié donnant des valeurs numériques bien vérifiées au premier ordre par l'expérience, et qui sera explicité ci-dessous en liaison avec les figures 3a et 3b.

Le transistor latéral selon les figures 3a et 3b est réalisé en technologie à isolation par oxyde, dite SUBILO, dans laquelle un substrat 10, par exemple de type p, est pourvu localement d'une couche enterrée fortement dopée du type opposé, donc n⁺. Le substrat 10 est recouvert d'une couche épitaxiale de type opposé, donc n, présentant des caissons localisés ici, 14 et 12, formant respectivement un caisson pour le transistor latéral et un caisson de contact de base 12 reliés électriquement l'un avec l'autre par la couche enterrée fortement dopée 11. Le caisson 14 a une forme générale carrée et le caisson 12 une forme générale rectangulaire. Ces deux caissons sont délimités sur leur pourtour par un oxyde (SiO₂) épais (épaisseur environ 1 à 1,5 microns) qui s'étend depuis la surface de la couche épitaxiale jusqu'au substrat et en interceptant le contour de la couche enterrée 11.

Le caisson 14 comporte des régions diffusées 15 et 16 de même type que le substrat 10, donc p. La région 15 est disposée au centre du caisson 14 et se présente en vue de dessus sous la forme d'un carré de côté $L_2$. Sa profondeur est h. Elle constitue l'émetteur du transistor latéral. La région 16 est limitée intérieurement par un carré espacé de la région d'émetteur 15, et extérieurement par l'oxyde épais 17. La région 18 du caisson 14 disposée entre l'émetteur 15 et le collecteur 16 constitue la base du transistor latéral.

Une couche isolante mince, par exemple d'oxyde et de nitrure de quelques dizièmes de micron d'épaisseur, est déposée à la surface de la couche épitaxiale et de l'oxyde épais 17, et présente des ouvertures destinées aux liaisons électriques du transistor. La liaison électrique d'émetteur est constituée par une plage métallique 21 de forme carrée et présente une zone 24 constituée par un carré de côté $L_1$ en contact effectif avec la région d'émetteur 15. La liaison électrique de base est constituée par une plage métallique 23 de forme rectangulaire en contact électrique avec la base 18 à travers successivement le caisson 12, la couche enterrée 11 et le caisson 14. La liaison électrique de collecteur est constituée par une plage métallique 22 dont les contours intérieur 26 et extérieur 27 sont délimités par des carrés, le contour extérieur 27 pouvant comme représenté se trouver au-dessus de l'oxyde épais 17.

Désignons par $J_m$ la densité de courant d'injection verticale des porteurs minoritaires sous la zone 24 de la métallisation d'émetteur 21, et par $J_o$ la densité de courant d'injection verticale des porteurs minoritaires sous l'oxyde 20 de l'émetteur 15. Désignons par $J_l$ la densité de courant d'injection latérale des porteurs minoritaires dans la base 18, du transistor latéral. Désignons enfin par $I_m$, $I_o$ et $I_l$ respectivement les courants d'injection, verticaux sous la zone 24 et sous l'oxyde 20 de l'émetteur 15, et latéral dans la base 18, correspondant aux densités de courants définies ci-dessus. On notera qu'on négligera notamment les recombinaisons dans la base.

Le gain en courant $\beta$ du transistor s'exprime alors de la manière suivante :

$$\beta = \frac{I_1}{I_m + I_o} = \frac{4kh\ L_2\ J_1}{J_o\ (L_2{}^2 - L_1{}^2) + Jm\ L_1{}^2} \qquad (1)$$

k étant un facteur de forme voisin de 1, et dépendant de la forme du profil de la jonction d'émetteur. Si on fixe à priori la valeur de $L_1$, notamment à la valeur minimale permise par le procédé de fabrication, par

4

exemple 3 microns, il vient alors :

$$\beta = \frac{AL_2}{L_2^2 + B} \qquad (2)$$

$$\text{avec } A = \frac{4J_1 kh}{J_0}$$

$$B = L_1^2 \left( \frac{J_m}{J_0} - 1 \right) = L_1^2 C$$

A, B et C sont des constantes. En effet, la demanderesse a mis en évidence que le rapport

$$r = \frac{J_m}{J_0}$$

est constant et déterminé uniquement par le procédé de fabrication. Sa valeur dépend de la qualité de la couche isolante 20, notamment des charges piégées dans celle-ci. Avec les procédés de fabrication actuels, on estime que sa valeur est de l'ordre de 50. On considère également en première approximation que le rapport

$$\frac{J_1}{J_0}$$

est constant et indépendant de la géométrie utilisée.

Ces hypothèses permettent maintenant de déterminer la valeur optimale de $L_2$. On a, en dérivant la formule (2) par rapport à $L_2$ :

$$\beta'(L_2) = \frac{A(B - L_2^2)}{(L_2^2 + B)^2} \qquad (3)$$

La courbe de gain en fonction de $L_2$ présente alors une valeur maximale pour $L_2^2 = B$, soit :

$$\frac{L_2^2}{L_1^2} = \frac{J_m}{J_0} - 1 = C \approx r$$

C'est-à-dire que le rapport entre la surface de la zone 24 et celle de l'émetteur 15 est égal à C, et ne dépend que du rapport entre les densités d'injection sous la métallisation et sous l'oxyde. Le gain optimal $\beta_{opt}$ a alors pour valeur :

$$\beta_{opt} = \frac{A}{2\sqrt{B}} \qquad (4)$$

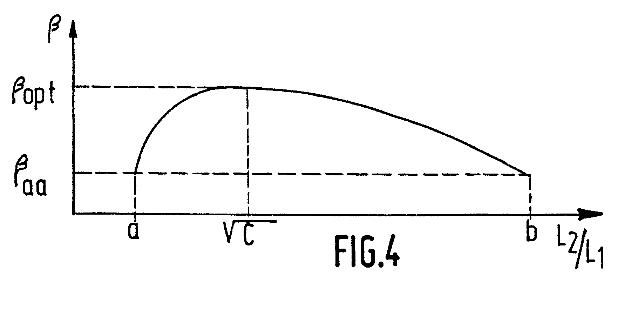

La courbe de gain en fonction du rapport $L_2/L_1$ pour $L_1$ donné est représentée à la figure 4. La partie ascendante de cette courbe ($L_2/L_1 < \sqrt{C}$) est relativement rapide, son sommet est assez plat et pour des rapports supérieurs au maximum sa décroissance est lente.

Dans l'art antérieur, le rapport $L_2/L_1 = a$ est en général compris entre 2 et 3. A titre d'exemple correspondant à a = 3, on a $L_1$ = 3 microns et $L_2$ = 9 microns, ce qui laisse une marge de 3 microns pour la tolérance de positionnement du masque utilisé pour ouvrir les fenêtres de métallisation d'émetteur augmentée d'une distance de sécurité évitant les court-circuits émetteur-base par ladite métallisation.

Le gain $\beta_{aa}$ d'un tel dispositif de l'art antérieur a alors pour valeur

$$\beta_{aa} = \frac{a \, A \, L_1}{a^2 \, L_1^2 + B} \qquad (5)$$

En rapprochant les formules (4) et (5) on obtient :

$$\frac{\beta_{opt}}{\beta_{aa}} = \frac{a^2 + C}{2a\sqrt{C}} \qquad (6)$$

Ce rapport ne dépend également que du rapport entre les densités d'injection sous la métallisation et sous l'oxyde. Pour r = 50 et a = 3, ce rapport vaut alors 1,38. On obtient donc toutes choses égales par ailleurs une amélioration d'environ 40 % par rapport à un transistor latéral de l'art antérieur de rapport a = 3.

Pour des valeurs de

$$\frac{L_2}{L_1}$$

supérieures à la valeur optimale la décroissance de la courbe est lente. Pour

$$\frac{L_2}{L_1}$$

= b, on retrouve la même valeur de gain $\beta_{aa}$. En rapprochant les formules (2) et (5), on obtient b = $\frac{C}{a}$ soit environ 17 dans l'exemple précédent, ce qui correspond à un rapport entre la surface d'émetteur et la zone de contact d'émetteur de l'ordre de 270.

On remarque que les calculs effectués ci-dessus, qui ne mettent en oeuvre que des rapports de surfaces, restent valables pour d'autres géométries, d'émetteur à contour convexe pour lesquelles il existe donc un optimum correspondant à un rapport entre la surface d'émetteur et la zone de contact d'émetteur égal à C, soit 50 environ dans l'exemple choisi, alors que dans l'art antérieur ce rapport ne dépasse en

EP 0 228 748 B1

général pas 9. Ce rapport surfacique peut être compris avantageusement entre 20 et 200. La limite inférieure correspondant à peu près à un doublement du rapport par rapport à l'art antérieur qui apporte une amélioration sensible du gain, et la limite supérieure à l'encombrement maximal généralement acceptable en pratique pour un émetteur de transistor latéral.

## Revendications

1. Procédé de fabrication d'un transistor latéral intégré dans lequel des régions d'émetteur et de collecteur d'un premier type de conductivité espacées latéralement sont réalisées à partir de la surface d'une région d'un deuxième type de conductivité opposé au premier, l'espace latéral de ladite région du deuxième type situé entre les régions d'émetteur et de collecteur formant une région de base du transistor, procédé dans lequel on réalise ensuite, à travers des fenêtres d'une couche isolante déposée au moins sur lesdites régions d'émetteur et de collecteur des liaisons électriques d'émetteur et de collecteur dont chacune présente une zone en contact électrique respectivement avec ladite région d'émetteur et avec ladite région de collecteur caractérisé en ce que la profondeur et le niveau de dopage de ladite région d'émetteur sont tels que la longueur de diffusion des porteurs minoritaires injectés verticalement dans celle-ci est supérieure ou égale à l'épaisseur de ladite région et en ce que la distance entre les périphéries de ladite zone de liaison électrique d'émetteur et de la région d'émetteur est, au moins sur une partie desdites périphéries en regard,nominalement supérieure à la tolérance d'alignement entre une dite fenêtre et une dite région d'émetteur et est choisie de manière telle que le gain du transistor soit supérieur à celui d'un transistor de même surface de zone de liaison électrique d'émetteur et dont ladite distance entre les périphéries de ladite zone de liaison électrique d'émetteur et de la région d'émetteur est égal nominalement à ladite tolérance d'alignement.

2. Procédé selon la revendication 1 caractérisée en ce que ladite zone de liaison électrique d'émetteur présente la surface minimale permise.

3. Procédé selon une des revendication 1 ou 2 caractérisé en ce que ladite zone de liaison électrique d'émetteur est un premier carré de côté $L_1$ s'inscrivant dans un deuxième carré de côté $L_2$ constituant ladite région d'émetteur, et en ce que $(L_2 - L_1)$ est supérieur à deux fois ladite tolérance d'alignement.

4. Procédé selon une des revendications 1 à 3 caractérisé en ce que le rapport entre la surface de ladite région l'émetteur et celle de ladite zone de liaison électrique d'émetteur est compris entre 20 et 200.

5. Procédé selon la revendication 4 caractérisé en ce que ledit rapport est sensiblement égal à r. r désignant le rapport entre la densité d'injection sous ladite zone de liaison électrique d'émetteur et la densité d'injection sous ladite couche isolante.

6. Dispositif semiconducteur avec un transistor latéral comportant des régions d'émetteur et de collecteur d'un premier type de conductivité espacées latéralement et disposées à partir de la surface d'une région d'un deuxième type de conductivité opposé au premier, l'espace latéral de ladite région du deuxième type situé entre les régions d'émetteur et de collecteur formant la base du transistor, et comportant des liaisons électriques d'émetteur et de collecteur dont chacune présente une zone en contact électrique à travers des fenêtres d'une couche isolante respectivement avec ladite région d'émetteur et avec ladite région de collecteur caractérisé en ce que la région d'émetteur présente une profondeur et un niveau de dopage tel que la longueur de diffusion des porteurs minoritaires injectés verticalement dans celle-ci est supérieure ou égale à l'épaisseur de ladite région, et en ce que le rapport entre la surface de ladite région d'émetteur et celle de ladite zone de liaison électrique d'émetteur est compris entre 20 et 200.

7. Dispositif semiconducteur selon la revendication 6 caractérisé en ce que ledit rapport est sensiblement égal à r, r désignant le rapport entre la densité d'injection sous ladite zone de liaison électrique d'émetteur et la densité d'injection sous ladite couche isolante.

8. Dispositif semiconducteur selon la revendication 7 caractérisé en ce que ledit rapport est sensiblement égal à 50.

9. Dispositif semiconducteur selon l'une des revendications 6 à 8, caractérisé en ce que ladite zone de

7

liaison électrique d'émetteur est un premier carré de côté $L_1$, s'inscrivant dans un deuxième carré de côté $L_2$ constituant ladite région d'émetteur, le rapport

$$\frac{L_2^2}{L_1^2}$$

étant compris entre 20 et 200, la région de collecteur ayant un contour intérieur carré enrourant la région d'émetteur.

10. Dispositif semiconducteur selon l'une des revendications 6 à 9 caractérisé en ce que ledit dispositif est un circuit intégré comportant ledit transistor latéral.

## Claims

1. A method of manufacturing an integrated lateral transistor, in which emitter and collector regions of a first conductivity type laterally spaced apart are obtained from the surface of a region of a second conductivity type opposite to the first, the lateral space of said region of the second conductivity type between the emitter and collector regions forming a base region of the transistor, in which method there are then formed through windows of an insulating layer deposited at least on said emitter and collector regions electrical emitter and collector connections, each of which has a zone in electrical contact with said emitter region and with said collector region, respectively, characterized in that the depth and the doping level of said emitter region are such that the diffusion length of the minority carriers injected vertically into it is larger than or equal to the thickness of said region and in that the distance between the peripheries of said electrical emitter connection zone and the emitter region is at least over a portion of said oppositely arranged peripheries nominally larger than the alignment tolerance between a said window and a said emitter region and is chosen so that the amplification of the transistor is larger than that of a transistor which has an electrical emitter connection of the same surface area and of which the said distance between the peripheries of the said electrical emitter connection zone and the said emitter region is nominally equal to the said alignment tolerance.

2. A method as claimed in Claim 1, characterized in that said electrical emitter connection zone has the minimum permitted surface.

3. A method as claimed in any one of Claims 1 or 2, characterized in that said electrical emitter connection zone is a first square having sides $L_1$ inscribed in a second square having sides $L_2$ constituting said emitter region, and in that $(L_2 - L_1)$ is larger than twice said alignment tolerance.

4. A method as claimed in any one of Claims 1 to 3, characterized in that the ratio between the surface of said emitter region and that of said electrical emitter connection zone lies between 20 and 200.

5. A method as claimed in Claim 4, characterized in that the said ratio is substantially equal to r, where r designates the ratio between the injection density under said electrical emitter connection zone and the injection density under said insulating layer.

6. A semiconductor device comprising a lateral transistor having emitter and collector regions of a first conductivity type laterally spaced apart and disposed from the surface of a region of a second conductivity type opposite to the first, the lateral part of said region of the second type between the emitter and collector regions forming the base of the transistor and comprising electrical emitter and collector connections, each of which has a zone in electrical contact through windows of an insulating layer with said emitter region and with said collector region, respectively, characterized in that the emitter region has a depth and a doping level such that the diffusion length of the minority carriers vertically injected into it is greater than or equal to the thickness of the said region and in that the ratio between the surface of said emitter region and that of said electrical emitter connection zone lies between 20 and 200.

7. A semiconductor device as claimed in Claim 6, characterized in that said ratio is substantially equal to

EP 0 228 748 B1

r, where r designates the ratio between the injection density under said electrical emitter connection zone and the injection density under said insulating layer.

8. A semiconductor device as claimed in Claim 7, characterized in that said ratio is substantially equal to 50.

9. A semiconductor device as claimed in any one of Claims 6 to 8, characterized in that said electrical emitter connection zone is a first square having sides $L_1$ inscribed in a second square having sides $L_2$ constituting the said emitter region, the ratio

$$\frac{L_2^2}{L_1^2}$$

lying between 20 and 200, the collector region having a square internal contour surrounding the emitter region.

10. A semiconductor device as claimed in any one of Claims 6 to 9, characterized in that said device is an integrated circuit comprising said lateral transistor.

## Patentansprüche

1. Verfahren zum Herstellen eines integrierten lateralen Transistors, in dem lateral einem Abstand voneinander liegende Emitter- und Kollektorgebiete vom einen Leitungstyp von der Oberfläche eines Gebietes eines dem erstgenannten entgegengesetzten Leitungstyps erhalten werden, wobei der laterale Raum des Gebietes vom zweiten Leitungstyp zwischen den Emitter- und den Kollektorgebieten ein Basisgebiet des Transistors bildet, wobei danach durch Fenster einer wenigstens auf den genannten Emitter- und Kollektorgebieten niedergeschlagenen Isolierschicht elektrische Emitter- und Kollektorverbindungen gebildet werden, die je eine mit dem genannten Emittergebiet bzw. dem genannten Kollektorgebiet in elektrischer Verbindung stehende Zone haben, dadurch gekennzeichnet, daß die Tiefe und der Dotierungspegel des genannten Emittergebietes derart sind, daß die Diffusionslänge der vertikal injizierten Minoritätsträger größer ist als die Dicke des genannten Gebietes oder dieser Dicke entspricht und daß der Abstand zwischen dem Umfang der genannten elektrischen Emitterverbindungszone und dem Emittergebiet wenigstens über einen Teil dieses Umfangs nominell größer ist als die Ausrichttoleranz zwischen einem genannten Fenster und einem genannten Emittergebiet und derart gewählt worden ist, daß die Verstärkung des Transistors größer ist als die eines Transistors mit einer elektrischen Emitterverbindung desselben Oberflächengebietes und wobei der genannte Abstand zwischen dem Umfang der genannten elektrischen Emitterverbindung und dem genannten Emittergebiet der genannten Ausrichttoleranz nominell entspricht.

2. Verfahren nach Anspruch 1, dadurch gekennzeichnet, daß die genannte elektrische Emitter-Verbindungszone die minimal erlaubte Oberfläche hat.

3. Verfahren nach einem der Ansprüche 1 oder 2, dadurch gekennzeichnet, daß die genannte elektrische Emitter-Verbindungszone ein erstes Quadrat mit einer Seite $L_1$ ist, das in einem zweiten das genannte Emittergebiet bildenden Quadrat mit einer Seite $L_2$ eingeschrieben ist, und daß ($L_2$ - $l_1$) größer ist als die doppelte genannte Ausrichttoleranz.

4. Verfahren nach einem der Ansprüche 1 bis 3, dadurch gekennzeichnet, daß das Verhältnis zwischen der Oberfläche des genannten Emittergebietes und der der genannten elektrischen Emitter-Verbindungszone zwischen 20 und 200 liegt.

5. Verfahren nach Anspruch 4, dadurch gekennzeichnet, daß das genannte Verhältnis nahezu gleich r ist, wobei r das Verhältnis zwischen der Injektionsdichte unterhalb der genannten elektrischen Emitter- Verbindungszone und der Injektionsdichte unterhalb der genannten Isolierschicht bezeichnet.

9

6. Halbleiteranordnung mit einem lateralen Transistor, in dem lateral in einem Abstand voneinander liegende Emitter- und Kollektorgebiete vom ersten Leitungstyp von der Oberfläche eines Gebietes eines dem erstgenannten entgegengesetzten Leitungstyps erhalten werden, wobei der laterale Raum des genannten Gebietes vom zweiten Leitungstyp zwischen den Emitter- und den Kollektorgebieten die Basis des Transistors bildet, und mit elektrischen Emitter- und Kollektor-Verbindungen, die je eine durch Fenster einer Isolierschicht mit dem genannten Emitter-Gebiet bzw. dem genannten Kollektorgebiet in elektrischer Verbindung stehende Zone aufweisen, dadurch gekennzeichnet, daß das Emitter-Gebiet eine derartige Tiefe und einen derartigen Dotierungspegel aufweist, daß die Diffusionslänge der vertikal darin injizierten Minoritätsträger größer ist als die Dicke des genannten Gebietes oder dieser Dicke entspricht und daß das Verhältnis zwischen der Oberfläche des genannten Emitter-Gebietes und der der genannten elektrischen Emitter-Verbindungszone zwischen 20 und 200 liegt.

7. Halbleiteranordnung nach Anspruch 6, dadurch gekennzeichnet, daß das genannte Verhältnis nahezu gleich r ist, wobei r das Verhältnis zwischen der Injektionsdichte unterhalb der genannten elektrischen Emitter-Verbindungszone und der Injektionsdichte unterhalb der genannten Isolierschicht bezeichnet.

8. Halbleiteranordnung nach Anspruch 7, dadurch gekennzeichnet, daß das genannte Verhältnis nahezu gleich 50 ist.

9. Halbleiteranordnung nach einem der Ansprüche 6 bis 8, dadurch gekennzeichnet, daß die genannte elektrische Emitter-Verbindungszone ein erstes Quadrat mit einer Seite $L_1$, ist, das in einem zweiten das genannte Emittergebiet bildenden Quadrat mit einer Seite $L_2$ eingeschrieben ist, wobei das Verhältnis $L_2^2/L_1^2$ zwischen 20 und 200 liegt, wobei das Kollektorgebiet einen das Emittergebiet umgebenden inneren quadratischen Umriß aufweist.

10. Halbleiteranordnung nach einem der Ansprüche 6 bis 9, dadurch gekennzeichnet, daß diese Anordnung eine integrierte Schaltung mit dem genannten lateralen Transistor ist.

**FIG.1**

**FIG.2**

**FIG.3a**

**FIG.3b**

FIG.4